# EUROPEAN PATENT APPLICATION

(11) **EP 2 416 443 A1**
(43) Date of publication of application: **08.02.2012**
(21) Application number: 11006017.5
(22) Date of filing: 22.07.2011
(51) Int. Cl.: H01Q 1/24, G06F 3/041, G06F 3/044, G06F 3/045

(54) **Method and system for utilizing a touchscreen interface as an antenna**

(30) Priority: 05.08.2010 US 371042 P; 25.10.2010 US 911408
(71) Applicant: Broadcom Corporation, Irvine, CA 92617 (US)
(72) Inventor: De Flaviis, Franco, 92617 Irvine, California (US)
(74) Representative: Jehle, Volker Armin

(57) **Abstract**

Methods and systems for utilizing a touchscreen interface as an antenna are disclosed and may include configuring one or more antennas in the touchscreen interface by capacitively-coupling conductive layers in the touchscreen interface. RF signals may be communicated utilizing the one or more configured antennas in the touchscreen interface. The coupled conductive layers may comprise a grid of conductive traces or an array of conductive patches. The conductive layers may comprise transparent materials. FM signals may be communicated utilizing the configured one or more antennas. The conductive layers may be capacitively coupled utilizing CMOS switches. Touch control commands and/or gestures may be sensed by the touchscreen interface utilizing capacitance, inductance resistance, and/or thermal measurements. Blocker signals may be nulled utilizing configured antennas in the touchscreen interface.

## Description

### CROSS-REFERENCE TO RELATED APPLICATIONS/INCORPORATION BY REFERENCE

This application makes reference to, claims the benefit from, and claims priority to United States Provisional Application Serial No. 61/371,042 filed on August 5, 2010.

This application also makes reference to United States Patent Application Serial No. 12/797,254 filed on June 9, 2010.

Each of the above stated applications is hereby incorporated herein by reference in its entirety.

### FEDERALLY SPONSORED RESEARCH OR DEVELOPMENT

[Not Applicable]

### [MICROFICHE/COPYRIGHT REFERENCE]

[Not Applicable]

### FIELD OF THE INVENTION

Certain embodiments of the invention relate to wireless communication. More specifically, certain embodiments of the invention relate to a method and system for utilizing a touchscreen interface as an antenna.

### BACKGROUND OF THE INVENTION

Mobile communications have changed the way people communicate and mobile phones have been transformed from a luxury item to an essential part of every day life. The use of mobile phones is today dictated by social situations, rather than hampered by location or technology. While voice connections fulfill the basic need to communicate, and mobile voice connections continue to filter even further into the fabric of every day life, the mobile Internet is the next step in the mobile communication revolution. The mobile Internet is poised to become a common source of everyday information, and easy, versatile mobile access to this data will be taken for granted.

Touchscreen user interfaces have become nearly ubiquitous in wireless devices. They allow the entry of complex user commands without the need of a keyboard or other mechanical input devices. Touchscreens typically comprise conductive material embedded in insulating material for sensing a user's touch through electrical or mechanical means, for example.

Further limitations and disadvantages of conventional and traditional approaches will become apparent to one of skill in the art, through comparison of such systems with the present invention as set forth in the remainder of the present application with reference to the drawings.

### BRIEF SUMMARY OF THE INVENTION

A system and/or method for utilizing a touchscreen interface as an antenna as shown in and/or described in connection with at least one of the figures, as set forth more completely in the claims.

According to an aspect, a method for communication is provided, the method comprising:
in a wireless device comprising a touchscreen interface:
   configuring one or more antennas in said touchscreen interface by capacitively-coupling conductive layers in said touchscreen interface; and
   communicating RF signals utilizing said one or more configured antennas in said touchscreen interface.

Advantageously, said coupled conductive layers comprise a grid of conductive traces.

Advantageously, said coupled conductive layers comprise an array of conductive patches.

Advantageously, said conductive layers comprise transparent materials.

Advantageously, the method further comprises communicating FM signals utilizing said configured one or more antennas.

Advantageously, the method further comprises capacitively-coupling said conductive layers utilizing CMOS switches.

Advantageously, the method further comprises sensing touch control commands and/or gestures by said touchscreen interface utilizing capacitance measurements.

Advantageously, the method further comprises sensing touch control commands and/or gestures by said touchscreen interface utilizing measurement of parameters varied by thermal changes.

Advantageously, the method further comprises sensing touch control commands and/or gestures by said touchscreen interface utilizing inductance measurements.

Advantageously, the method further comprises sensing touch control commands and/or gestures by said touchscreen interface utilizing resistance measurements.

Advantageously, the method further comprises nulling blocker signals via one or more configured antennas in said touchscreen interface.

According to an aspect, a system for enabling communication comprises:
one or more circuits for use in a wireless device comprising a touchscreen interface, said one or more circuits being operable to:
   configure one or more antennas in said touchscreen interface by capacitively-coupling conductive layers in said touchscreen interface; and
   communicate RF signals utilizing said one or more configured antennas in said touchscreen interface.

Advantageously, said coupled conductive layers comprise a grid of conductive traces.

Advantageously, said coupled conductive layers comprise an array of conductive patches.

Advantageously, said conductive layers comprise transparent materials.

Advantageously, said one or more circuits are operable to communicate FM signals utilizing said configured one or more antennas.

Advantageously, said one or more circuits are operable to capacitively-couple said conductive layers utilizing CMOS switches.

Advantageously, said one or more circuits are operable to sense touch control commands and/or gestures by said touchscreen interface utilizing capacitance measurements.

Advantageously, said one or more circuits are operable to sense touch control commands and/or gestures by said touchscreen interface utilizing measurement of parameters varied by thermal changes.

Advantageously, said one or more circuits are operable to sense touch control commands and/or gestures by said touchscreen interface utilizing inductance measurements.

Advantageously, said one or more circuits are operable to sense touch control commands and/or gestures by said touchscreen interface utilizing resistance measurements.

Advantageously, said one or more circuits are operable to null blocker signals via one or more configured antennas in said touchscreen interface.

Various advantages, aspects and novel features of the present invention, as well as details of an illustrated embodiment thereof, will be more fully understood from the following description and drawings.

### BRIEF DESCRIPTION OF SEVERAL VIEWS OF THE DRAWINGS

FIG. 1 is a block diagram of an exemplary wireless system with a touchscreen interface utilized as an antenna, which may be utilized in accordance with an embodiment of the invention.

FIG. 2 is a block diagram illustrating an exemplary touchscreen interface with configurable antennas, in accordance with an embodiment of the invention.

FIG. 3 is a block diagram illustrating an exemplary grid touchscreen interface with a configured serpentine antenna, in accordance with an embodiment of the invention.

FIG. 4 is a block diagram illustrating exemplary steps for communicating via antennas integrated in a touchscreen interface, in accordance with an embodiment of the invention.

### DETAILED DESCRIPTION OF THE INVENTION

Certain aspects of the invention may be found in a method and system for utilizing a touchscreen interface as an antenna. Exemplary aspects of the invention may comprise configuring one or more antennas in the touchscreen interface by capacitively-coupling conductive layers in the touchscreen interface. RF signals may be communicated utilizing the one or more configured antennas in the touchscreen interface. The coupled conductive layers may comprise a grid of conductive traces or an array of conductive patches. The conductive layers may comprise transparent materials. FM signals may be communicated utilizing one or more of the configured antennas. The conductive layers may be capacitively coupled utilizing CMOS switches. Touch control commands and/or gestures may be sensed by the touchscreen interface utilizing capacitance, inductance resistance, and/or thermal measurements. Blocker signals may be nulled utilizing configured antennas in the touchscreen interface.

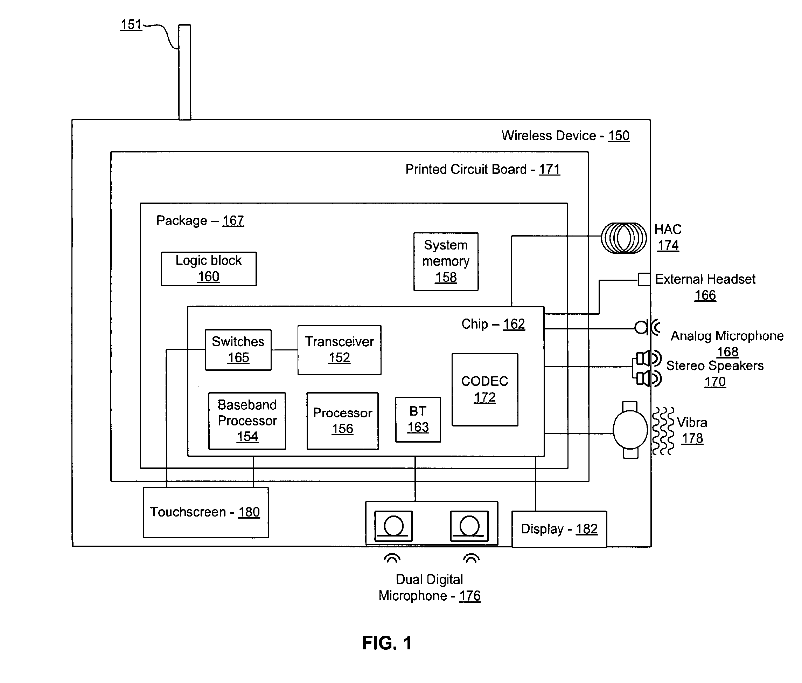

FIG. 1 is a block diagram of an exemplary wireless system with a touchscreen interface utilized as an antenna, which may be utilized in accordance with an embodiment of the invention. Referring to FIG. 1, the wireless device 150 may comprise an antenna 151, a transceiver 152, a baseband processor 154, a processor 156, a system memory 158, a logic block 160, a chip 162, switches 165, an external headset port 166, and an integrated circuit package 167. The wireless device 150 may also comprise an analog microphone 168, integrated hands-free (IHF) stereo speakers 170, a printed circuit board 171, a hearing aid compatible (HAC) coil 174, a dual digital microphone 176, a vibration transducer 178, a touchscreen interface 180, and a display 182.

The transceiver 152 may comprise suitable logic, circuitry, interface(s), and/or code that may be enabled to modulate and upconvert baseband signals to RF signals for transmission by one or more antennas, which may be represented generically by the antenna 151. The transceiver 152 may also be enabled to downconvert and demodulate received RF signals to baseband signals. The RF signals may be received by one or more antennas, which may be represented generically by the antenna 151, or by one or more antennas configured within the touchscreen interface 180. Different wireless systems may use different antennas for transmission and reception. The transceiver 152 may be enabled to execute other functions, for example, filtering the baseband and/or RF signals, and/or amplifying the baseband and/or RF signals.

Although a single transceiver 152 is shown, the invention is not so limited. Accordingly, the transceiver 152 may be implemented as a separate transmitter and a separate receiver. In addition, there may be a plurality of transceivers, transmitters and/or receivers. In this regard, the plurality of transceivers, transmitters and/or receivers may enable the wireless device 150 to handle a plurality of wireless protocols and/or standards including cellular, WLAN and PAN. Wireless technologies handled by the wireless device 150 may comprise FM, GSM, CDMA, CDMA2000, WCDMA, GMS, GPRS, EDGE, WIMAX, WLAN, 3GPP, UMTS, BLUETOOTH, and ZigBee, for example.

The baseband processor 154 may comprise suitable logic, circuitry, interface(s), and/or code that may be enabled to process baseband signals for transmission via the transceiver 152 and/or the baseband signals received from the transceiver 152. The processor 156 may be any suitable processor or controller such as a CPU, DSP, ARM, or any type of integrated circuit processor. The processor 156 may comprise suitable logic, circuitry, and/or code that may be enabled to control the operations of the transceiver 152 and/or the baseband processor 154. For example, the processor 156 may be utilized to update and/or modify programmable parameters and/or values in a plurality of components, devices, and/or processing elements in the transceiver 152 and/or the baseband processor 154. At least a portion of the programmable parameters may be stored in the system memory 158.

Control and/or data information, which may comprise the programmable parameters, may be transferred from other portions of the wireless device 150, not shown in FIG. 1, to the processor 156. Similarly, the processor 156 may be enabled to transfer control and/or data information, which may include the programmable parameters, to other portions of the wireless device 150, not shown in FIG. 1, which may be part of the wireless device 150.

The processor 156 may utilize the received control and/or data information, which may comprise the programmable parameters, to determine an operating mode of the transceiver 152. For example, the processor 156 may be utilized to select a specific frequency for a local oscillator, a specific gain for a variable gain amplifier, configure the local oscillator and/or configure the variable gain amplifier for operation in accordance with various embodiments of the invention. Moreover, the specific frequency selected and/or parameters needed to calculate the specific frequency, and/or the specific gain value and/or the parameters, which may be utilized to calculate the specific gain, may be stored in the system memory 158 via the processor 156, for example. The information stored in system memory 158 may be transferred to the transceiver 152 from the system memory 158 via the processor 156.

The system memory 158 may comprise suitable logic, circuitry, interface(s), and/or code that may be enabled to store a plurality of control and/or data information, including parameters needed to calculate frequencies and/or gain, and/or the frequency value and/or gain value. The system memory 158 may store at least a portion of the programmable parameters that may be manipulated by the processor 156.

The logic block 160 may comprise suitable logic, circuitry, interface(s), and/or code that may enable controlling of various functionalities of the wireless device 150. For example, the logic block 160 may comprise one or more state machines that may generate signals to control the transceiver 152 and/or the baseband processor 154. The logic block 160 may also comprise registers that may hold data for controlling, for example, the transceiver 152 and/or the baseband processor 154. The logic block 160 may also generate and/or store status information that may be read by, for example, the processor 156. Amplifier gains and/or filtering characteristics, for example, may be controlled by the logic block 160.

The BT radio/processor 163 may comprise suitable circuitry, logic, interface(s), and/or code that may enable transmission and reception of Bluetooth signals. The BT radio/processor 163 may enable processing and/or handling of BT baseband signals. In this regard, the BT radio/processor 163 may process or handle BT signals received and/or BT signals transmitted via a wireless communication medium. The BT radio/processor 163 may also provide control and/or feedback information to/from the baseband processor 154 and/or the processor 156, based on information from the processed BT signals. The BT radio/processor 163 may communicate information and/or data from the processed BT signals to the processor 156 and/or to the system memory 158. Moreover, the BT radio/processor 163 may receive information from the processor 156 and/or the system memory 158, which may be processed and transmitted via the wireless communication medium a Bluetooth headset, for example.

The CODEC 172 may comprise suitable circuitry, logic, interface(s), and/or code that may process audio signals received from and/or communicated to input/output devices. The input devices may be within or communicatively coupled to the wireless device 150, and may comprise the analog microphone 168, the stereo speakers 170, the hearing aid compatible (HAC) coil 174, the dual digital microphone 176, and the vibration transducer 178, for example. The CODEC 172 may be operable to up-convert and/or down-convert signal frequencies to desired frequencies for processing and/or transmission via an output device. The CODEC 172 may enable utilizing a plurality of digital audio inputs, such as 16 or 18-bit inputs, for example. The CODEC 172 may also enable utilizing a plurality of data sampling rate inputs. For example, the CODEC 172 may accept digital audio signals at sampling rates such as 8 kHz, 11.025 kHz, 12 kHz, 16 kHz, 22.05 kHz, 24 kHz, 32 kHz, 44.1 kHz, and/or 48 kHz. The CODEC 172 may also support mixing of a plurality of audio sources. For example, the CODEC 172 may support audio sources such as general audio, polyphonic ringer, I²S FM audio, vibration driving signals, and voice. In this regard, the general audio and polyphonic ringer sources may support the plurality of sampling rates that the audio CODEC 172 is enabled to accept, while the voice source may support a portion of the plurality of sampling rates, such as 8 kHz and 16 kHz, for example.

The chip 162 may comprise an integrated circuit with multiple functional blocks integrated within, such as the transceiver 152, the processor 156, the baseband processor 154, the BT radio/processor 163, and the CODEC 172. The number of functional blocks integrated in the chip 162 is not limited to the number shown in FIG. 1. Accordingly, any number of blocks may be integrated on the chip 162 depending on chip space and wireless device 150 requirements, for example. The chip 162 may be flip-chip bonded, for example, to the package 167.

The touchscreen interface 180 may comprise a multi-layer structure of insulating and conducting material that may be operable to control operation of the wireless device 180 by sensing the touch of one or more fingers to the surface of the touchscreen interface 180. For example, a grid of conductive traces may be embedded in insulating material for sensing charge and/or capacitance differences generated by the presence of one or more fingers on the surface. In another exemplary embodiment of the invention, the touchscreen interface 180 may comprise one or more conductive layers with a grid of contact points, with each point individually addressable, thereby enabling multi-touch sensing capability. Additionally, one or more antennas may be configured in the touchscreen interface 180 by capacitive coupling of the conductive traces such that signals for transmission may be well above that of the normal operational frequencies of the touchscreen interface 180. In this manner, various antennas may be dynamically configured based on the wireless needs of the wireless device 150 and/or the wireless environment.

The switches 165 may comprise switches such as CMOS or MEMS switches that may be operable to couple elements in the touchscreen interface 180 to the transceiver 152 via capacitors and/or other impedances. In this manner, one or more antennas in the touchscreen interface 180 may be coupled to appropriate amplifiers in the transceiver 152 for transmission of wireless signals while also providing impedance matching. Accordingly, capacitors may be coupled to the touchscreen interface 180, thereby providing AC-coupling for wireless signals to be communicated, while also providing DC blocking for lower frequency control signals generated from touchscreen commands.

The external headset port 166 may comprise a physical connection for an external headset to be communicatively coupled to the wireless device 150. The analog microphone 168 may comprise suitable circuitry, logic, interface(s), and/or code that may detect sound waves and convert them to electrical signals via a piezoelectric effect, for example. The electrical signals generated by the analog microphone 168 may comprise analog signals that may require analog to digital conversion before processing.

The package 167 may comprise a ceramic package, a printed circuit board, or other support structure for the chip 162 and other components of the wireless device 150. In this regard, the chip 162 may be bonded to the package 167. The package 167 may comprise insulating and conductive material, for example, and may provide isolation between electrical components mounted on the package 167.

The stereo speakers 170 may comprise a pair of speakers that may be operable to generate audio signals from electrical signals received from the CODEC 172. The HAC coil 174 may comprise suitable circuitry, logic, and/or code that may enable communication between the wireless device 150 and a T-coil in a hearing aid, for example. In this manner, electrical audio signals may be communicated to a user that utilizes a hearing aid, without the need for generating sound signals via a speaker, such as the stereo speakers 170, and converting the generated sound signals back to electrical signals in a hearing aid, and subsequently back into amplified sound signals in the user's ear, for example.

The dual digital microphone 176 may comprise suitable circuitry, logic, interface(s), and/or code that may be operable to detect sound waves and convert them to electrical signals. The electrical signals generated by the dual digital microphone 176 may comprise digital signals, and thus may not require analog to digital conversion prior to digital processing in the CODEC 172. The dual digital microphone 176 may enable beamforming capabilities, for example.

The vibration transducer 178 may comprise suitable circuitry, logic, interface(s), and/or code that may enable notification of an incoming call, alerts and/or message to the wireless device 150 without the use of sound. The vibration transducer may generate vibrations that may be in synch with, for example, audio signals such as speech or music.

In operation, control and/or data information, which may comprise the programmable parameters, may be transferred from other portions of the wireless device 150, not shown in FIG. 1, to the processor 156. Similarly, the processor 156 may be enabled to transfer control and/or data information, which may include the programmable parameters, to other portions of the wireless device 150, not shown in FIG. 1, which may be part of the wireless device 150.

The processor 156 may utilize the received control and/or data information, which may comprise the programmable parameters, to determine an operating mode of the transceiver 152. For example, the processor 156 may be utilized to select a specific frequency for a local oscillator, a specific gain for a variable gain amplifier, configure the local oscillator and/or configure the variable gain amplifier for operation in accordance with various embodiments of the invention. Moreover, the specific frequency selected and/or parameters needed to calculate the specific frequency, and/or the specific gain value and/or the parameters, which may be utilized to calculate the specific gain, may be stored in the system memory 158 via the processor 156, for example. The information stored in system memory 158 may be transferred to the transceiver 152 from the system memory 158 via the processor 156.

The CODEC 172 in the wireless device 150 may communicate with the processor 156 in order to transfer audio data and control signals. Control registers for the CODEC 172 may reside within the processor 156. The processor 156 may exchange audio signals and control information via the system memory 158. The CODEC 172 may up-convert and/or down-convert the frequencies of multiple audio sources for processing at a desired sampling rate.

One or more antennas may be configured in conductive traces in the touchscreen interface 180 and may be operable to communicate high frequency signals to and/or from the surface of the touchscreen interface 180. Since the normal operations of the touchscreen, sensing fingertips, swiping, and expanding images, for example, are at a much lower frequency, such as the multi-kHz range, the configuration of high frequency antennas in the touchscreen interface 180 may not affect these normal operations.

Different frequency signals may be transmitted and/or received by antennas by selectively coupling the transceiver 152 to antennas with different lengths in the touchscreen interface 180. For example, a serpentine antenna may be configured utilizing much of the surface of the touchscreen interface 180, and may be operable to communicate FM signals. In another exemplary embodiment, a plurality of antennas may be configured in the touchscreen interface 180 for antenna diversity and/or beam-forming, for example.

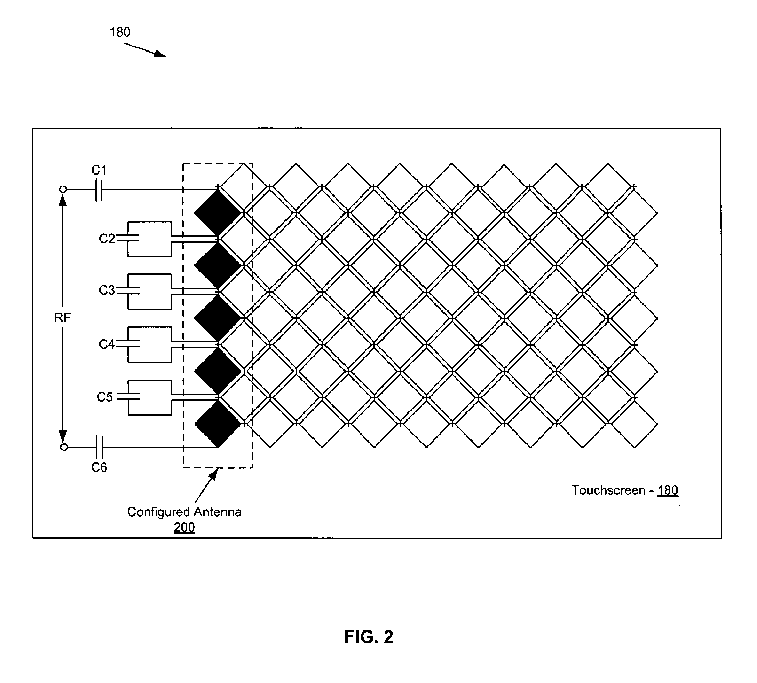

FIG. 2 is a block diagram illustrating an exemplary touchscreen interface with configurable antennas, in accordance with an embodiment of the invention. Referring to FIG. 2, there is shown the touchscreen interface 180 comprising an array of conductive patches that may be operable to sense touch via resistive, capacitive, thermal, and/or pressure changes, for example, at each of the patches. The conductive patches, not shown to scale, may be embedded in insulating material, such as glass, for example, or may be exposed for direct contact with a user's fingers, and may comprise a transparent conductive material, such as indium-tin-oxide (ITO).

There is also shown the coupling capacitors C1-C6, that may be operable to provide AC-coupling of RF signals to and/or between the conductive patches in the touchscreen interface 180. The capacitors C1-C6 may effectively block lower frequency signals, such as from normal touchscreen function commands, which may operate in the multi-kHz frequency range, while coupling higher frequency RF signals. Thus, RF signals may be communicated to and from the conductive patches in the touchscreen interface 180 without significant interference with the normal operation of the touchscreen functions.

In operation, the capacitors C1-C6 may be coupled to conductive patches in the touchscreen interface 180 via switches such as the switches 165 described with respect to FIG. 1. In the exemplary embodiment shown, a linear array of conductive patches may be coupled by the capacitors C1-C6, thereby providing a configured antenna 200 that may be operable to communicate RF signals. The invention is not limited to the linear array shown in FIG. 2. Accordingly, any shape and size of antenna may be configured, depending on the number of conductive patches, the number of coupling capacitors and switches, and the desired RF frequency, for example.

In another embodiment of the invention, the configured antenna 200 may not only be used to transmit and/or receive signals, but may also be utilized to null interference in a specific direction. For example, in a BT connection the pattern of radiation may be shaped utilizing different conductive patches in the touchscreen interface 180 such that a blocker signal from another device and/or link may be nulled and thereby maximize the reception. For example, in instances where a blocker signal is present, and equal magnitude but opposite phase signal may be transmitted by one or more antennas configured in the touchscreen interface 180.

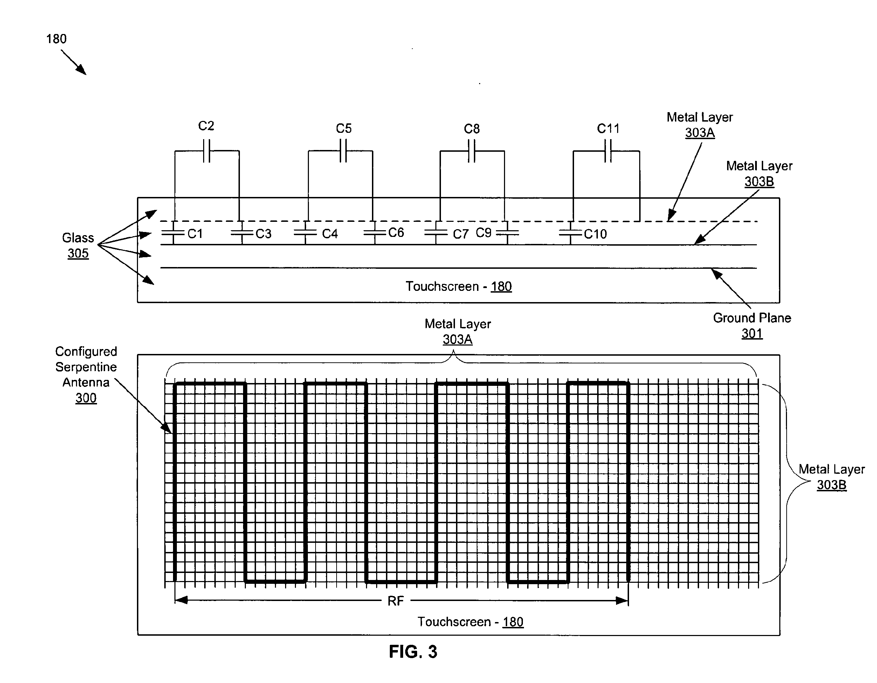

FIG. 3 is a block diagram illustrating an exemplary grid touchscreen interface with a configured serpentine antenna, in accordance with an embodiment of the invention. Referring to FIG. 3, there is shown the touchscreen interface 180 comprising an array of conductive traces comprising the metal layers 303A and 303B, and the ground plane 301. The metal layers 303A and 303B may be utilized to sense touch via resistive, capacitive, thermal, and/or pressure changes measured at grid intersections. The metal layers 303A and 303B, and the ground plane 301 may be embedded in insulating material, such as the glass 305, for example, and may comprise a transparent conductive material, such as indium-tin-oxide (ITO).

There is also shown the coupling capacitors C1-C11, that may be operable to provide AC-coupling of RF signals to and/or between the metal layers 303A and 303B in the touchscreen interface 180. The capacitors C1-C11 may effectively block lower frequency signals, such as from normal touchscreen function commands, which may operate in the multi-kHz frequency range, while coupling higher frequency RF signals. Thus, RF signals may be communicated to and from desired traces in the metal layers 303A and 303B in the touchscreen interface 180 without significant interference with the normal operation of the touchscreen functions.

In operation, the capacitors C1-C11 may be coupled to and/or between the metal layers 303A and 303B in the touchscreen interface 180 via switches such as the switches 165 described with respect to FIG. 1. For example the capacitors C1, C3, C4, C6, C7, C9, and C10 may be operable to couple traces in the metal layer 303A to traces in the metal layer 303B, whereas the capacitors C2, C5, C8, and C11 may be operable to provide coupling between traces within the metal layer 303A.

In the exemplary embodiment shown, a serpentine structure may thus be configured, thereby providing a configured serpentine antenna 300 that may be operable to communicate RF signals. By configuring an antenna over much of the surface of the touchscreen interface 180, an FM antenna may be configured without requiring large discrete antennas in the wireless device 150. The invention is not limited to the serpentine structure shown in FIG. 3. Accordingly, any shape and size of antenna may be configured, depending on the number of traces in the metal layers 303A and 303B, the number of coupling capacitors and switches, and the desired RF frequency, for example.

In another embodiment of the invention, the configured serpentine antenna 300 may not only be used to transmit and/or receive signals, but may also be utilized to null interference in a specific direction. For example, in a BT connection the pattern of radiation may be shaped utilizing different conductive patches in the touchscreen interface 180 such that a blocker signal from another device and/or link may be nulled and thereby maximize the reception. For example, in instances where a blocker signal is present, and equal magnitude but opposite phase signal may be transmitted by one or more antennas configured in the touchscreen interface 180.

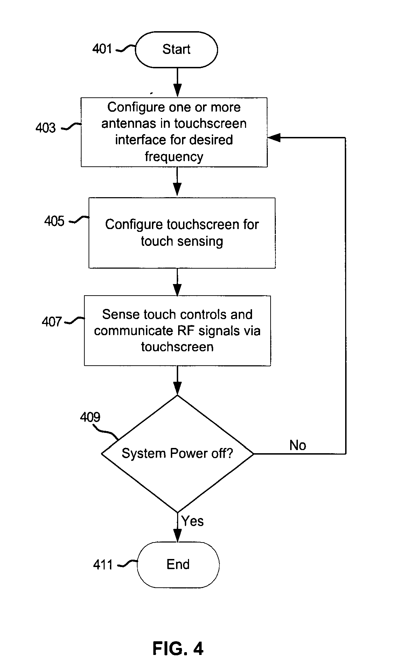

FIG. 4 is a block diagram illustrating exemplary steps for communicating via antennas integrated in a touchscreen interface, in accordance with an embodiment of the invention. Referring to FIG. 4, in step 403 after start step 401, one or more antennas in the touchscreen interface may be configured utilizing coupling capacitors. In step 405, the touchscreen interface may be configured for sensing of touch control signals from the user. In step 407, user touch control signals may be received by the touchscreen while communicating RF signals via the capacitively-coupled antennas in the touchscreen interface. In step 409, in instances where the wireless device 150 is to be powered down, the exemplary steps may proceed to end step 411. In step 409, in instances where the wireless device 150 is not to be powered down, the exemplary steps may proceed to step 403 to configure one or more antennas in the touchscreen interface.

In an embodiment of the invention, a method and system are disclosed for configuring one or more antennas in the touchscreen interface 180 by capacitively-coupling conductive layers 301, 303A, and/or 303B in the touchscreen interface 180. RF signals may be communicated utilizing the one or more configured antennas 200, 300 in the touchscreen interface 180. The coupled conductive layers 301, 303A, and/or 303B may comprise a grid of conductive traces or an array of conductive patches. The conductive layers may comprise transparent materials. FM signals may be communicated utilizing the configured one or more antennas 200, 300. The conductive layers 301, 303A, and/or 303B may be capacitively coupled utilizing CMOS switches 165. Touch control commands may be sensed by the touchscreen interface 180 utilizing capacitance, inductance resistance, and/or thermal measurements. Blocker signals may be nulled utilizing configured antennas 200, 300 in the touchscreen interface 180.

Other embodiments of the invention may provide a non-transitory computer readable medium and/or storage medium, and/or a non-transitory machine readable medium and/or storage medium, having stored thereon, a machine code and/or a computer program having at least one code section executable by a machine and/or a computer, thereby causing the machine and/or computer to perform the steps as described herein for utilizing a touchscreen interface as an antenna.

Accordingly, aspects of the invention may be realized in hardware, software, firmware or a combination thereof. The invention may be realized in a centralized fashion in at least one computer system or in a distributed fashion where different elements are spread across several interconnected computer systems. Any kind of computer system or other apparatus adapted for carrying out the methods described herein is suited. A typical combination of hardware, software and firmware may be a general-purpose computer system with a computer program that, when being loaded and executed, controls the computer system such that it carries out the methods described herein.

One embodiment of the present invention may be implemented as a board level product, as a single chip, application specific integrated circuit (ASIC), or with varying levels integrated on a single chip with other portions of the system as separate components. The degree of integration of the system will primarily be determined by speed and cost considerations. Because of the sophisticated nature of modern processors, it is possible to utilize a commercially available processor, which may be implemented external to an ASIC implementation of the present system. Alternatively, if the processor is available as an ASIC core or logic block, then the commercially available processor may be implemented as part of an ASIC device with various functions implemented as firmware.

The present invention may also be embedded in a computer program product, which comprises all the features enabling the implementation of the methods described herein, and which when loaded in a computer system is able to carry out these methods. Computer program in the present context may mean, for example, any expression, in any language, code or notation, of a set of instructions intended to cause a system having an information processing capability to perform a particular function either directly or after either or both of the following: a) conversion to another language, code or notation; b) reproduction in a different material form. However, other meanings of computer program within the understanding of those skilled in the art are also contemplated by the present invention.

While the invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiments disclosed, but that the present invention will include all embodiments falling within the scope of the appended claims.

## Claims

1. A method for communication, the method comprising:
in a wireless device comprising a touchscreen interface:
configuring one or more antennas in said touchscreen interface by capacitively-coupling conductive layers in said touchscreen interface; and
communicating RF signals utilizing said one or more configured antennas in said touchscreen interface.

2. The method according to claim 1, wherein said coupled conductive layers comprise a grid of conductive traces.

3. The method according to claim 1, wherein said coupled conductive layers comprise an array of conductive patches.

4. The method according to claim 1, wherein said conductive layers comprise transparent materials.

5. The method according to claim 1, comprising communicating FM signals utilizing said configured one or more antennas.

6. The method according to claim 1, comprising capacitively-coupling said conductive layers utilizing CMOS switches.

7. The method according to claim 1, comprising sensing touch control commands and/or gestures by said touchscreen interface utilizing capacitance measurements.

8. The method according to claim 1, comprising sensing touch control commands and/or gestures by said touchscreen interface utilizing measurement of parameters varied by thermal changes.

9. The method according to claim 1, comprising sensing touch control commands and/or gestures by said touchscreen interface utilizing inductance measurements.

10. The method according to claim 1, comprising sensing touch control commands and/or gestures by said touchscreen interface utilizing resistance measurements.

11. The method according to claim 1, comprising nulling blocker signals via one or more configured antennas in said touchscreen interface.

12. A system for enabling communication, the system comprising:
one or more circuits for use in a wireless device comprising a touchscreen interface, said one or more circuits being operable to:
configure one or more antennas in said touchscreen interface by capacitively-coupling conductive layers in said touchscreen interface; and
communicate RF signals utilizing said one or more configured antennas in said touchscreen interface.

13. The system according to claim 12, wherein said coupled conductive layers comprise a grid of conductive traces.

14. The system according to claim 12, wherein said coupled conductive layers comprise an array of conductive patches.

15. The system according to claim 12, wherein said conductive layers comprise transparent materials.
